(19) Europäisches Patentamt / European Patent Office / Office européen des brevets

(11) **EP 1 783 789 A1**

(12) **EUROPEAN PATENT APPLICATION**

(43) Date of publication:
**09.05.2007 Bulletin 2007/19**

(51) Int Cl.:
*H01F 41/04* (2006.01)   *H01F 17/04* (2006.01)
*H01F 27/28* (2006.01)

(21) Application number: **06020617.4**

(22) Date of filing: **29.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **30.09.2005 JP 2005288434**
**29.09.2006 JP 2006267488**

(71) Applicant: **TDK Corporation**
**Tokyo 103-8272 (JP)**

(72) Inventor: **Masai, Taku**
**TDK Corp.**
**Tokyo, 103-8272 (JP)**

(74) Representative: **Müller - Hoffmann & Partner**
**Patentanwälte,**
**Innere Wiener Strasse 17**
**81667 München (DE)**

(54) **Thin film device and thin film inductor**

(57) Provided is a thin film device capable of ensuring operating performance by ensuring the adhesion of a conductive film and the magnetic characteristic of a magnetic film. A substrate has a surface roughness (an arithmetic mean roughness Ra) within the range expressed in the expression: $X \mu m \leqq Ra \leqq 0.1 \mu m$. A lower limit X of the surface roughness Ra is a value determined based on a series of parameters including an internal stress $\sigma$, a thickness T, and an adhesiveness P per unit length of a conductive film. An anchor effect can be used to ensure the adhesion of the conductive film, and also ensure the magnetic characteristic (magnetic permeability) even when a magnetic film is provided on a substrate having a surface irregular structure.

FIG. 1

**Description**

BACKGROUND OF THE INVENTION

Field of the Invention

The present invention relates to a thin film device with a conductive film and a magnetic film each being layered on a substrate, and a thin film inductor with a coil and a magnetic film each being layered on a substrate.

Description of the Related Art

Recently, in the field of devices for various purposes, a thin film device with a conductive film and a magnetic film each being layered on a substrate is widely used. As an example of this thin film device, there is a thin film inductor having a coil for generating inductance as the above-mentioned conductive film. This thin film inductor has a structure including mainly a coil filled in with an insulating film , and a magnetic film, the coil and the magnetic film being layered on a substrate.

In order to ensure the operating performance of thin film devices, it is necessary to ensure both of the adhesion property of the conductive film and the magnetic characteristic of the magnetic film. Considering the recent technical trend that there is the widening demand for improved operating performance of the thin film devices, it seems necessary to optimize not only the configurations of the conductive film and the magnetic film, but also the configuration of the substrate.

Several techniques of ensuring the operating performance of the thin film devices have already been proposed. Specifically, there is known the technique of forming a coil by plating on a substrate (a ferrite substrate) having a surface roughness (an arithmetic mean roughness Ra) of 0.003 $\mu$m to 0.6 $\mu$m, in order to achieve miniaturization, high efficiency, and high output of a thin film inductor (refer to, for example, Japanese Unexamined Patent Publication No. 11-168010). In relation to the above-mentioned surface roughness of the substrate, there is known the technique of polishing the surface of a substrate until it has a surface roughness (a maximum height Rmax) of 0.8 $\mu$m or less, before the surface of the substrate is subjected to amorphous coating in order to increase the adhesion of an amorphous alloy film (refer to, for example, Japanese Unexamined Patent Publication No. 05-117838).

SUMMARY OF THE INVENTION

As described above, it is essential to ensuring of the operating performance of the thin film device that both of adhesion and magnetic characteristic be ensured. Nevertheless, in the thin film devices of the related art, adhesion and magnetic characteristic are not completely satisfactory, and hence there is much room for improvement. Particularly, in order to ensure the operating performance of the thin film device, not only to ensure adhesion and magnetic characteristic, but also to enable the thin film device to be stably manufactured is important.

In view of the foregoing, it is desirable to provide a thin film device capable of ensuring operating performance by ensuring the adhesion of a conductive film and the magnetic characteristic of a magnetic film.

It is also desirable to provide a thin film inductor capable of ensuring operating performance by ensuring the adhesion of a coil and the magnetic characteristic of a magnetic film.

According to an embodiment of the present invention, there is provided a thin film device with a conductive film and a magnetic film each being layered on a substrate having a surface roughness within a range expressed in the following expression (1) and expression (2):

$$X\,\mu m \leqq Ra \leqq 0.1\,\mu m \quad \cdots (1)$$

$$X = [(\sigma^2 T^2 W^2 - W^2 P^2)/16 P^2]^{0.5} \quad \cdots (2)$$

where Ra is a surface roughness (an arithmetic mean roughness ($\mu$m)) of the substrate; $\sigma$ is an internal stress (MPa) of the conductive film; T is a thickness ($\mu$m) of the conductive film; W is a peak-to-peak pitch ($\mu$m) of irregularities providing that concaves and convexes are uniformly formed on a surface of the substrate; and P is adhesiveness (MPa) per unit length of the conductive film.

The term 'substrate' means all kinds of base materials (or base members) which are able to support some film structure formed thereon, specifically including bare substrate with no modification as well as composite substrate and modified substrate (or reformed substrate), where the composite substrate is a composition of bare substrate and some structure formed thereon, the structure including other bare substrate and/or a film formed of one or more layers, and the modified substrate is a bare substrate whose surface has been subjected to some modification process.

In this thin film device, the surface roughness of the substrate is within the range expressed in the expression (1) and the expression (2). Consequently, an anchor effect can be used to ensure the adhesion of the conductive film, and magnetic characteristic (magnetic permeability) can also be ensured even if a magnetic film is provided on a substrate having a rough surface.

Preferably, the surface roughness of the substrate lies within a range expressed in the following expression (3):

$$\mathrm{Ra} \leqq 0.075\,\mu\mathrm{m} \quad \cdots (3)$$

or within a range expressed in the following expression (4):

$$0.004\,\mu\mathrm{m} \leqq \mathrm{Ra} \quad \cdots (4)$$

Particularly, the conductive film may have a seed film and a plated film in that order from the substrate, the plated film being grown with use of the seed film.

According to an other embodiment of the present invention, there is provided a thin film inductor with a coil and a magnetic film each being layered on a substrate having a surface roughness within a range expressed in the following expression (5) and expression (6):

$$\mathrm{X}\,\mu\mathrm{m} \leqq \mathrm{Ra} \leqq 0.1\,\mu\mathrm{m} \quad \cdots (5)$$

$$\mathrm{X} = [(\sigma^2 \mathrm{T}^2 \mathrm{W}^2 - \mathrm{W}^2 \mathrm{P}^2)/16\mathrm{P}^2]^{0.5} \quad \cdots (6)$$

where Ra is a surface roughness (an arithmetic mean roughness ($\mu$m)) of the substrate; $\sigma$ is an internal stress (MPa) of the coil; T is a thickness ($\mu$m) of the coil; W is a peak-to-peak pitch ($\mu$m) of irregularities providing concaves and convexes are uniformly formed on a surface of the substrate; and P is adhesiveness (MPa) per unit length of the coil.

In this thin film inductor, the surface roughness of the substrate is within the range expressed in the expression (5) and the expression (6). Like the above-mentioned thin film device, the adhesion of the coil can be ensured and the magnetic characteristic (magnetic permeability) of the magnetic film can also be ensured.

In the thin film device in accordance with the present invention, the substrate has a surface roughness within the range expressed in the expression (1) and the expression (2). Therefore, by ensuring the adhesion of the conductive film and the magnetic characteristic of the magnetic film, operating performance can be obtained.

In the thin film inductor in accordance with the present invention, the substrate has a surface roughness within the range expressed in the expression (5) and the expression (6). Hence, the adhesion property of the coil and the magnetic characteristic of the magnetic film can be ensured, enabling operating performance to be ensured.

Other and further objects, features and advantages of the invention will appear more fully from the following description.

BRIEF DESCRIPTION OF THE DRAWINGS

Fig. 1 is a sectional view showing the cross-sectional configuration of a thin film device according to an embodiment of the present invention;
Fig. 2 is a sectional view showing in enlarged dimension a part of the thin film device shown in Fig. 1;
Fig. 3 is a sectional view for explaining the principle of calculating the lower limit of the surface roughness of a substrate;

Fig. 4 is a sectional view showing an example of the configuration of a conductive film;

Fig. 5 is a sectional view for explaining the step of forming the conductive film shown in Fig. 4;

Fig. 6 is a sectional view showing the step subsequent to that of Fig. 5;

Fig. 7 is a sectional view showing an example of modifications related to the configuration of the thin film device according to an embodiment of the present invention;

Fig. 8 is a sectional view showing another example of the modifications related to the configuration of the thin film device according to an embodiment of the present invention;

Fig. 9 is a plan view showing the plan structure of a thin film inductor in the embodiment of the present invention;

Fig. 10 is a sectional view showing a cross-sectional configuration taken along the line X-X of the thin film inductor shown in Fig. 9;

Fig. 11 is a sectional view showing an example of the configuration of a coil;

Fig. 12 is a sectional view showing an example of modifications of the thin film inductor in the embodiment of the present invention;

Fig. 13 is a plan view showing the plan structure of a thin film inductor in another embodiment of the present invention;

Fig. 14 is a sectional view showing a cross-sectional configuration taken along the line XIV-XIV of the thin film inductor shown in Fig. 13;

Fig. 15 is a sectional view showing a cross-sectional configuration taken along the line XV-XV of the thin film inductor shown in Fig. 13;

Fig. 16 is a sectional view showing a cross-sectional configuration taken along the line XVI-XVI of the thin film inductor shown in Fig. 13; and

Fig. 17 is a diagram showing the correlation between surface roughness and magnetic permeability.

DESCRIPTION OF THE PREFERRED EMBODIMENTS

Preferred embodiments of the present invention will now be described in detail with reference to the accompanying drawings.

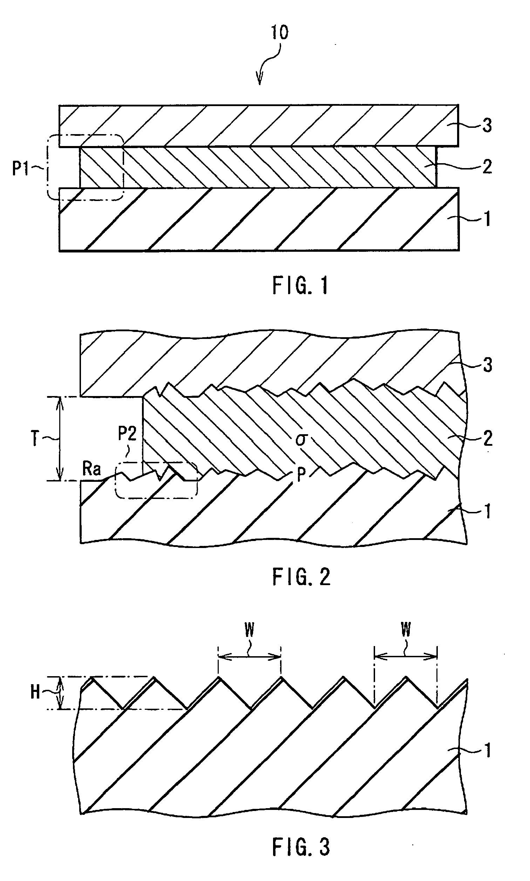

Reference to Figs. 1 and 2, the structure of a thin film device according to an embodiment of the present invention will be described as follows. Fig. 1 shows the cross-sectional configuration of a thin film device 10. Fig. 2 shows in enlarged dimension a site (a site P1) of the thin film device 10 shown in Fig. 1.

The thin film device 10 of this is to be used in the field of devices for various purposes and applied to, for embodiment example, thin film inductors, thin film transformers, thin film sensors, thin film actuators, thin film magnetic heads, or MEMS (micro electro mechanical systems).

The thin film device 10 is constructed of a conductive film 2 and a magnetic film 3 each being layered on a substrate 1, as shown in Fig. 1. The detailed configuration of the thin film device 10 can be determined freely as long as the conductive film 2 and the magnetic film 3 are layered on the substrate 1. That is, the layer configuration (monolayer or multilayer) of the conductive film 2, the layer configuration (monolayer or multilayer) of the magnetic film 3, and the laminate configuration (the order of layering) of the conductive film 2 and the magnetic film 3 can be set suitably depending on the condition, such as the application of the thin film device 10. Alternatively, the thin film device 10 may have other element (not shown), in addition to the above-mentioned conductive film 2 and the magnetic film 3. Examples of the "other element" are an insulating film electrically isolating between the substrate 1 and the conductive film 2, an insulating film electrically isolating the conductive film 2 from its surroundings, and an insulating film electrically isolating between the conductive film 2 and the magnetic film 3.

Here, the thin film device 10 has, for example, the structure including the conductive film 2 of monolayer, and the magnetic film 3 of monolayer, each being layered in this order on the substrate 1.

The substrate 1 may be any kind of base materials (or base members) which are able to support some film structure formed thereon, specifically including bare substrate with no modification as well as composite substrate and modified substrate (or reformed substrate), where the composite substrate is a composition of bare substrate and some structure formed thereon, the structure including other bare substrate and/or a film formed of one or more layers, and the modified substrate is a bare substrate whose surface has been subjected to some modification process.

The conductive film 2 is a functional film performing various functions by using electrical conduction. For example, the conductive film 2 is constructed of a conductive material represented by various metals. The three dimensional structure of the conductive film 2 can be set freely depending on the various functions. For example, the conductive film 2 may have a flat structure when it functions as an electrode, or a winding structure when it works as a coil for generating inductance. The winding structure may, for example, be a spiral structure or solenoid structure, but is not limited in such structures. Figs. 1 and 2 show the case where the conductive film 2 has the flat structure, for example.

The magnetic film 3 is a functional film performing various functions by using magnetism. For example, the magnetic film 3 is constructed of a magnetic material represented by various alloys.

As shown in Fig. 2, when the thin film device 10 is viewed microscopically, the conductive film 2 is formed so as to cover the substrate 1 having surface roughness. Consequently, the conductive film 2 has a rough surface caused by the surface roughness of the substrate 1, and the magnetic film 3 is formed so as to cover the conductive film 2 having the rough surface.

Particularly, in the thin film device 10, the substrate 1 has a certain surface roughness. The term "surface roughness" indicates a so-called arithmetic mean roughness Ra, and it is within the range expressed in the following expression (11) and expression (12). The principle of calculating the lower limit X of the surface roughness Ra expressed in the expression (11) and the expression (12) will be described later.

$$X\,\mu m \leqq Ra \leqq 0.1\,\mu m \quad \cdots (11)$$

$$X = [(\sigma^2 T^2 W^2 - W^2 P^2) / 16P^2]^{0.5} \quad \cdots (12)$$

where Ra is a surface roughness ($\mu$m) of the substrate 1; $\sigma$ is an internal stress (MPa) of the conductive film 2; T is a thickness ($\mu$m) of the conductive film 2; W is a width ($\mu$m) of irregularities providing concaves and convexes are uniformly formed on a surface of the substrate 1; and P is adhesiveness (MPa) per unit length of the conductive film 2.

The reason why the surface roughness Ra is preferable to be equal or more than X[$\mu$m] in the expression (12), namely (Ra $\geqq$ X $\mu$m), is to enable ensuring of the adhesion of the conductive film 2. As used herein, "the adhesion of the conductive film 2" depending on the surface roughness Ra means the adhesion to the substrate 1 as the base, namely adhesion utilizing a so-called anchor effect. As described previously, "the adhesiveness P per unit length of the conductive film 2" means adhesion utilizing no anchor effect, and it can simply be determined based on characteristic matching between materials.

On the other hand, the reason why it is preferable that the surface roughness Ra be within the range of 0.1 $\mu$m or less (Ra $\leqq$ 0.1 $\mu$m) is to enable ensuring of the magnetic characteristic (the magnetic permeability $\mu$) of the magnetic film 3 even if the magnetic film 3 is provided on the substrate 1 having the surface irregular structure.

The mechanism that the surface roughness Ra influences on the magnetic characteristic of the magnetic film 3 is as follows. That is, when a magnetic filed is applied in a direction parallel with the film surface of the magnetic film 3, the magnetization of the magnetic film 3 is reversed. The reversal of magnetization is caused based on the phenomenon that by applying the magnetic field to the magnetic film 3, energy is supplied to a magnetic spin and the magnetic spin is reversed with this energy. The degree of tendency of the magnetization reversal is so-called magnetic permeability $\mu$. The magnetic permeability $\mu$ will be lowered due to disturbance of the reversal of magnetization by the presence of impurities, crystal defect, and the like. The magnetic permeability $\mu$ will also be lowered due to disturbance of the magnetic domain structure in the magnetic film 3 by the presence of a large surface irregularity (large surface roughness Ra) of the base. Hence, the surface roughness Ra of the substrate 1 can exert an adverse effect upon the magnetic characteristic of the magnetic film 3. More particularly, when the surface roughness Ra is too large, the magnetic characteristic is deteriorated due to a reduction in the magnetic permeability $\mu$.

For purposes of confirmation, in the case as shown in Fig. 2, the conductive film 2 directly adheres to the substrate 1, and hence the adhesion of the conductive film 2 means the adhesion to the substrate 1, and the adhesiveness P means the adhesiveness of the conductive film 2 to the substrate 1. On the other hand, in the case where the above-mentioned insulating film (not shown) as the other element is interposed between the substrate 1 and the conductive film 2, and the conductive film 2 indirectly adheres to the substrate 1 with the insulating film in between, the adhesion of the conductive film 2 means substantially the adhesion to the insulating film, and the adhesiveness P means the adhesiveness of the conductive film 2 to the insulating film.

Preferably, the surface roughness Ra is, for example, within the range expressed in the following expression (13):

$$Ra \leqq 0.075\,\mu m \quad \cdots (13)$$

When the surface roughness Ra is 0.075 $\mu$m or less, the magnetic film 3 is capable of achieving a magnetic permeability $\mu$ of the equivalent or more of the magnetic permeability $\mu$ when the surface roughness Ra is almost zero (the adverse effect due to the surface roughness Ra is negligibly small).

Preferably, the surface roughness Ra is, for example, within the range expressed in the following expression (14):

$$0.004\ \mu m \leqq Ra \cdots (14)$$

When the surface roughness Ra is 0.004 $\mu$m or more, the adhesion of the conductive film 2 can be ensured when the internal stress $\sigma$, the thickness T, the width W, and the adhesiveness P are set in a practical range, as will be described later.

If the surface roughness Ra of the substrate 1 prepared for configuring the thin film device 10 is not in the range as shown in the expression (11) and the expression (12), the surface roughness Ra can be adjusted so as to fall within a suitable range by treatment of the substrate in various ways. As an example, if a silicon substrate (a so-called silicon wafer) or the like having a considerably small surface roughness Ra is used as the substrate 1, the surface roughness Ra can be increased into a suitable range by intentionally roughing the surface of the substrate 1 by using processing techniques represented by dry etching, sandblast, or ion milling.

Reference to Figs. 1 to 3, the principle of calculating the lower limit X of the surface roughness Ra expressed in the expression (12) will be described as follows. Fig. 3 is to explain the principle of calculating the lower limit of the surface roughness Ra of the substrate 1, illustrating in enlarged dimension the surface irregular structure of the substrate 1.

The lower limit X of the surface roughness Ra is a threshold value to be defined from the point of view of ensuring the adhesion of the conductive film 2, as described above, and it can be calculated by considering the thin film device 10 in Figs. 1 and 2, as a two-dimensional model.

Specifically, when a series of parameters of the surface roughness Ra ($\mu$m) of the substrate 1, the internal stress $\sigma$ (MPa) of the conductive film 2, the thickness T ($\mu$m) of the conductive film 2, and the adhesiveness P (MPa) per unit length of the conductive film 2 are set to the thin film device 10, as shown in Fig. 2, a shear stress F1 (MPa $\cdot$ $\mu$m) exerted on the interface between the substrate 1 and the conductive film 2 can be expressed in the following expression (21):

$$F1 = \sigma \times T \cdots (21)$$

Here, the internal stress $\sigma$ may be considered to be concentrated at a site (a site P2) having a length of about 1 $\mu$m in the vicinity of one end of the conductive film 2. This is because a partial delaminating of the conductive film 2 from the substrate 1, originating from the site P2 in the vicinity of the one end, may be considered to cause the whole of the conductive film 2 to start peeling from the substrate 1. As used herein, the term "length" means a dimension in a lateral direction as viewed in Fig. 2.

When the conductive film 2 is in contact with the substrate 1 having the rough surface, the junction length (the effective junction length) of the conductive film 2 is greater than that when the conductive film 2 is in contact with the flat substrate 1, so that the adhesiveness (the effective adhesiveness) is increased. The effective adhesiveness per unit length of the conductive film 2, namely F2 (MPa $\cdot$ $\mu$m), can be expressed in the following expression (22):

$$F2 = P \times L \cdots (22)$$

where L ($\mu$m) is an effective junction length per unit length of the conductive film 2.

From these two expressions (21) and (22), the condition under which the conductive film 2 does not delaminated from the substrate 1 can be expressed in the following expression (23), and hence it can substantially be expressed in the following expression (24).

$$F2 \geqq F1 \cdots (23)$$

$$P \times L \geqq \sigma \times T \cdots (24)$$

This effective junction length L satisfies the correlation expressed in the following expression (25):

$$L = \int \sqrt{1 + \{f(x)\}^2}\ dx \qquad \cdots \ (25)$$

where f(x) is a function related to the surface irregular structure of the substrate 1, namely a function indicating a height from a specific reference surface.

At this time, the surface roughness Ra satisfies the correlation expressed in the following expression (26):

$$Ra = \int_0^D \frac{|f(x)|}{D} dx \qquad \cdots \ (26)$$

where the surface roughness Ra can be obtained by extracting from a roughness curve by a reference length D in a direction of an average line of the roughness curve, and summing and then averaging the absolute values of deviation from the average line of the extracted portion to a measured curve.

By specifying the surface roughness Ra from these two expressions (25) and (26), the effective junction length L can be calculated. The surface roughness Ra and the effective junction length L can also be actually measured with a contact unevenness meter or the like.

Here, it is assumed that the surface of the substrate 1 is uniformly provided with irregularities (or pebbling), as shown in Fig. 3. Then, when the width of the irregularities is W ($\mu$m), and the height of the irregularities is H ($\mu$m), there are present 1/W pieces of irregularities per unit width (1 $\mu$m in width). As used herein, the term "the width of irregularities" is a so-called pitch of irregularities (a distance between concave portions or a distance between convex portions), and the term "the height of irregularities" is a so-called height of the convex portions. The effective junction length L in this case can be expressed in the following expression (27). Particularly, when the surface of the substrate 1 is uniformly provided with the concaves and convexes, the surface roughness Ra can be expressed in the following expression (28). Therefore, from these two expressions (27) and (28), the effective junction length L can be expressed in the following expression (29).

$$L = (2/W) \times [(W/2)^2 + H^2]^{0.5} \quad \cdots \ (27)$$

$$Ra = H/2 \quad \cdots \ (28)$$

$$L = (2/W) \times [(W/2)^2 + 4Ra^2]^{0.5} \quad \cdots \ (29)$$

Accordingly, by introducing the expression (29), the above-mentioned expression (24) can be expressed in the following expression (30):

$$P \times \{(2/W) \times [(W/2)^2 + 4Ra^2]^{0.5}\} \geqq \sigma \times T \quad \cdots \ (30)$$

By changing the expression (30), the surface roughness Ra, namely a threshold value to be defined from the point of view of ensuring the adhesion of the conductive film 2, can be expressed in the following expression (31):

$$Ra = [(\sigma^2 T^2 W^2 - W^2 P^2)/16P^2]^{0.5} \quad \cdots \ (31)$$

This enables to calculate the lower limit X (=Ra) of the surface roughness Ra expressed in the expression (12).

As an example of specific ranges of the surface roughness Ra, in the case where, as the configuration of a practical thin film device 10, the substrate 1 (silicon oxide (typically SiO$_2$)) and the conductive film 2 (copper (Cu)) are included under the conditions of 27.8 MPa in internal stress σ, 20 μm in thickness T, 0.1 μm in width W, and 270 MPa in adhesiveness P, the fact that the surface roughness Ra is necessary to satisfy the expression: 0.004 μm ≦ Ra ≦ 0.1 μm, can be found from the above-mentioned expressions (11) and (12).

In the thin film device of this embodiment, the surface roughness Ra of the substrate 1 is within the range as expressed in the expressions (11) and (12). This enables to optimize the surface roughness Ra of the substrate 1 from the point of view of ensuring both of the adhesion of the conductive film 2 and the magnetic characteristic (the magnetic permeability) of the magnetic film 3, as discussed above. Hence, ensuring the adhesion of the conductive film 2 and the magnetic characteristic of the magnetic film 3 can ensure the operating performance.

In particular, the present embodiment is capable of further improving the magnetic characteristic of the magnetic film 3, if the surface roughness Ra falls within the range expressed in the expression (13).

The present embodiment is also capable of ensuring the adhesion of the conductive film 2 when the internal stress σ, the thickness T, the width W, and the adhesiveness P are set in a practical range, if the surface roughness Ra falls within the range expressed in the expression (14).

Description will now be made of the technical significance of the present invention. That is, in order to ensure the operating performance of the thin film device 10 by ensuring both of the adhesion of the conductive film 2 and the magnetic characteristic of the magnetic film 3, the present invention defines a proper range of the surface roughness Ra of the substrate 1, as shown in the expressions (11) and (12). With regard to the surface roughness Ra, the above-mentioned publication (Japanese Unexamined Patent Publication No. 11-168010) discloses the technique of setting the surface roughness Ra of a substrate (a ferrite substrate) to 0.003 μm to 0.6 μm. Although the present invention is similar to the technique of this publication in view of defining the surface roughness Ra of a substrate, the present invention is essentially different from this technique. This is because the technique of this publication is to specify a proper range of the surface roughness Ra to be restrictively applied only to several kinds of substrates, including the ferrite substrate, and to define the proper range of the surface roughness Ra with no logical consideration of the reason why the performance is improved. In contrast, the present invention specifies a general expression (a character expression) generally applicable to every substrate (irrespective of the material of the substrate), along with a proper range of the surface roughness Ra based on physical characteristic data (magnetic permeability μ), and also defines a proper range by logically considering the reason why the performance is improved, from the point of view of the adhesion property and magnetic characteristic.

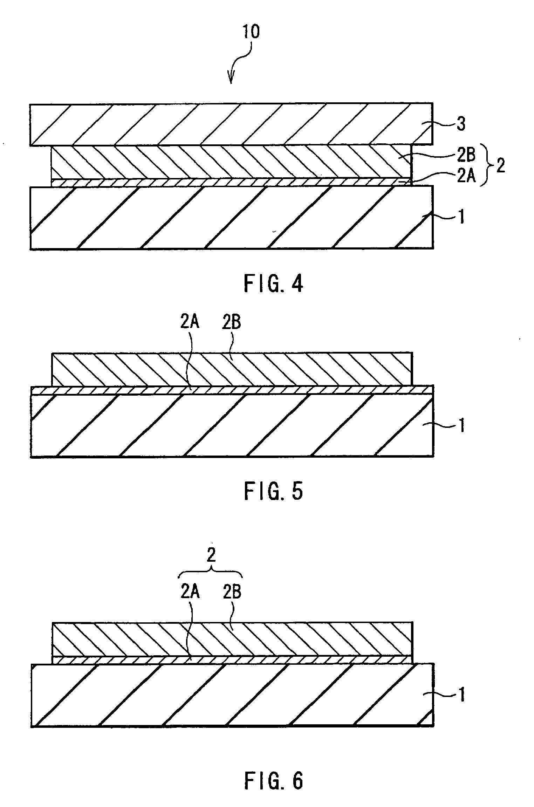

In the present embodiment, the configuration (the forming method) of the conductive film 2 can be set freely. For example, as shown in Fig. 4 corresponding to Fig. 1, by forming the conductive film 2 with an electro-plating method, the conductive film 2 may be configured so as to have a seed film 2A, and a plated film 2B grown with use of the seed layer 2A, the seed film 2A being closer to the substrate 1 than the plate film 2B. In this case, the adhesiveness P per unit length of the conductive film 2 is the adhesiveness per unit length of the seed layer 2A. The material constituting the seed layer 2A may be identical with or different from that of the plated film 2B.

The conductive film 2 can be formed through the procedure, for example, as shown in Figs. 5 and 6 corresponding to Fig. 4. That is, when forming a conductive film 2, as shown in Fig. 5, a seed film 2A is firstly formed so as to cover the substrate 1, and then a plated film 2B is formed in a pattern by electro plating with use of the seed layer 2A. In this case, for example, a photoresist pattern (not shown) is used to selectively grow the plated film 2B, and the used photoresist pattern is then removed. Subsequently, as shown in Fig. 6, the unnecessary portions of the seed film 2A are etched away by wet etching or the like. This results in the conductive film 2 having the seed film 2A and the plated film 2B.

Even if the conductive film 2 is configured as described with reference to Figs. 4 to 6, the same effect as in the foregoing embodiment can be obtained. Otherwise, the configuration of the thin film device 10 shown in Fig. 4 is identical to that shown in Fig. 1.

Particularly, in the case as shown in Figs. 4 to 6, the thin film device 10 can be manufactured stably from the point of view of manufacturing process, for the reason as follows. That is, as shown in Fig. 5 and 6, when the unnecessary portions of the seed film 2A are etched away by wet etching, if the surface roughness Ra is beyond the range expressed in the expression (11), (Ra>0.1 μm), the surface irregularities of the substrate 1 is too large. Therefore, an etchant is hard to reach fine portions (vacancies (deeply recessed portions)). As a result, poor etching is liable to occur, making it difficult to stably manufacture the thin film device 10. In contrast, in the present embodiment, because the surface roughness Ra falls within the range expressed in the expression (11), (Ra≦0.1 μm), the surface irregularities of the substrate 1 is not too large. Therefore, an etchant is easy to reach the fine portions. This suppresses poor etching and permits stable manufacturing of the thin film device 10.

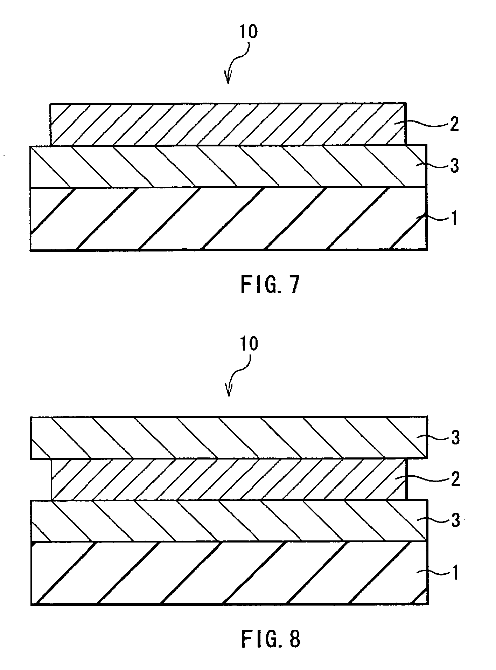

Although in the present embodiment, the thin film device 10 is configured so as to have the laminate structure that the conductive film 2 and the magnetic film 3 are layered in this order on the substrate 1, as shown in Fig. 1, the configuration of the thin film device 10 is not limited to this, and it can be set suitably depending on the condition such as use and the like, as described above. As a specific example, the thin film device 10 may be configured so as to have a laminate structure including the magnetic film 3 and the conductive film 2 layered in this order on the substrate 1, as shown in Fig. 7 corresponding to Fig. 1. Alternatively, the thin film device 10 may be configured so as to have a laminate structure including the magnetic film 3, the conductive film 2, and the magnetic film 3, which are layered in this order on the substrate 1, in other words, the conductive film 2 is interposed between the two magnetic films 3. These two alternatives also provide the same effect as the forgoing embodiment. Otherwise, the configurations of the thin film devices 10 shown in Figs. 7 and 8, respectively, are identical to that shown in Fig. 1.

This completes the description of the thin film device according to the embodiment of the present invention.

Description will next be made of an example of applications of the above-mentioned thin film device. In the following, Fig. 1 referred to describe the thin film device 10 will be referred to whenever it is necessary.

(First Thin Film Inductor)

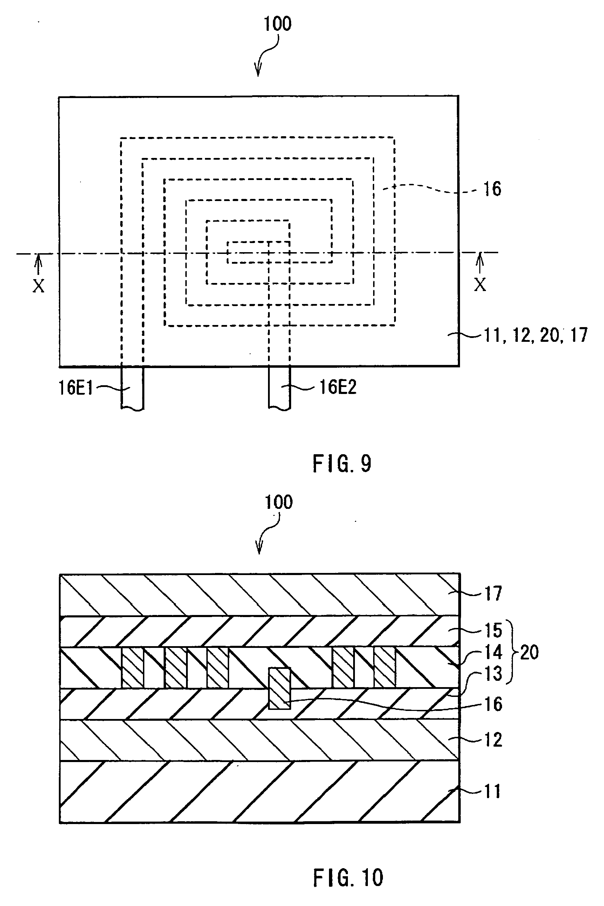

Figs. 9 and 10 show the configuration of a thin film inductor 100 to which applied is the thin film device 10 (refer to Fig. 1); Fig. 9 shows its plan configuration; and Fig. 10 shows a cross-sectional configuration taken along the line X-X in Fig. 9.

As shown in Figs. 9 and 10, for example, the thin film inductor 100 can be constructed of a lower magnetic film 12 and an upper magnetic film 17 deposited on a substrate 11 in this order in a direction away from the substrate 11, and a coil 16 deposited between the lower magnetic film 12 and the upper magnetic film 17. For example, the coil 16 is filled in with an insulating film 20 disposed between the upper magnetic film 12 and the lower magnetic film 17. In other words, the thin film inductor 100 has the structure that the lower magnetic film 12, the coil 16 filled in with the insulating film 20, and the upper magnetic film 17 are layered in this order on the substrate 11.

The substrate 11 corresponds to the substrate 1 (refer to Fig. 1), and has a surface roughness Ra expressed in the expressions (11) and (12). For example, the substrate 11 may be selected from various substrates of glass, silicon (Si), silicon oxide, aluminium oxide ($Al_2O_3$, being so-called alumina), ceramic, a semiconductor, or a resin, and these various substrates with various functional films. It should be understood that the material constituting the substrate 11 is not limited to the above-mentioned materials. In fact, one could use any other material.

Especially, in order to improve the magnetic characteristic of the thin film inductor 100, it is preferable that the substrate 11 be a magnetic substrate such as a ferrite substrate. Particularly, a ferrite substrate of nickel copper zinc alloy (NiCuZn) having an insulating property is suitable because it enables to directly form the coil 16 on the substrate 11, for the purpose of simplifying the configuration and omitting some of the manufacturing process of the thin film inductor 100.

The lower magnetic film 12 and the upper magnetic film 17 correspond to the magnetic film 3 (refer to Fig. 1), respectively, and have a function of enhancing inductance. The lower magnetic film 12 and the upper magnetic film 17 are constructed of, for example, a magnetic material represented by a cobalt (Co) alloy or an iron (Fe) alloy. As an example of cobalt alloys, there is a cobalt zirconium tantalum alloy (CoZrTa), a cobalt zirconium niobium alloy (CoZrNb), or the like. As an example of iron alloys, there is a cobalt iron alloy (CoFe) or the like.

The insulating film 20 electrically isolates the coil 16 from its surroundings. For example, the insulating film 20 has a three-layer structure that a lower insulating film 13 supporting the coil 16, an intermediate insulating film 14 filling in between the windings of the coil 16 and its surroundings, and an upper insulating film 15 covering the coil 16 are layered in this order in a direction away from the lower magnetic film 12. The lower insulating film 13, the intermediate insulating film 14, and the upper insulating film 15 are respectively constructed of an insulating material such as silicon oxide. The configuration of the insulating film 20 is not limited to the above-mentioned three-layer structure, and it can be changed freely.

The coil 16 corresponds to the conductive film 2 (refer to Fig. 1), and is constructed of a conductive material represented by metal, such as copper, nickel (Ni), or silver (Ag). For example, the coil 16 has a spiral structure that one end (a terminal 16E1) and the other end (a terminal 16E2) are led out to the outside of the insulating film 20, so as to generate inductance between these two terminals 16E1 and 16E2. The adhesiveness P expressed in the above-mentioned expression (12), namely an adhesiveness P per unit length of the coil 16 corresponding to the conductive film 2, is substantially an adhesiveness to the insulating film 20 (the lower insulating film 13).

In the thin film inductor 100, the surface roughness Ra of the substrate 11 is within the range expressed in the expressions (11) and (12). Therefore, by the same mechanism as the thin film device 10, the adhesion of the coil 16 can be ensured, and the magnetic characteristic (the magnetic permeability) of the lower magnetic film 12 and the upper magnetic film 17 can also be ensured. This enables to ensure operating performance.

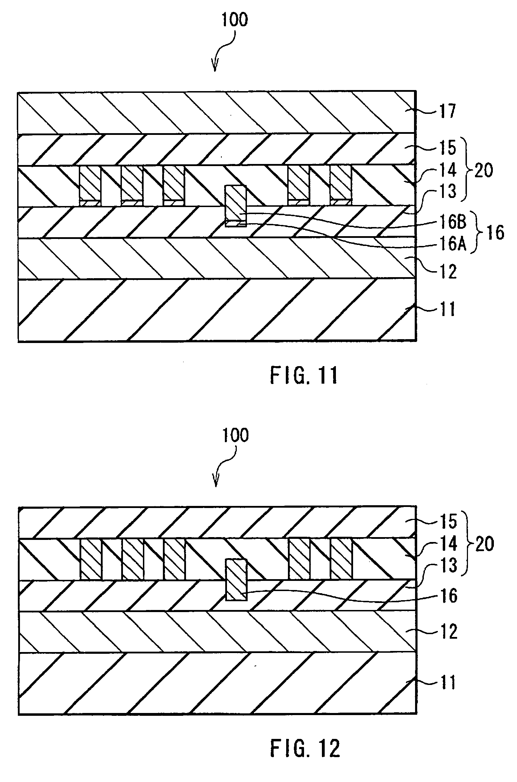

In this case, especially, the magnetic path of the thin film inductor 100 become closer to a closed magnetic path because the coil 16 is interposed between the lower magnetic film 12 and the upper magnetic film 17. It is therefore possible to improve magnetic characteristic more than the case where only the lower magnetic film 12 is provided without having the upper magnetic film 17, as shown in Fig. 12 to be described later.

Of course, in the thin film inductor 100, the coil 16 may be configured so as to include a seed layer 16A and a plated film 16B as shown in Fig. 11 corresponding to Fig. 10, by applying the configuration example of the conductive film 2 as described with reference to Fig. 4. In this case, the thin film inductor 100 can be manufactured stably by the same mechanism as the thin film device 10 in the foregoing description. Otherwise, the configuration of the thin film inductor 100 shown in Fig. 11 is identical to that shown in Fig. 10.

Alternatively, the thin film device 100 may be configured so as to have only the lower magnetic film 12 without having the upper magnetic film 17, as shown in Fig. 12 corresponding to Fig. 10. This also ensures operating performance as in the case shown in Fig. 10. Otherwise, the configuration of the thin film inductor 100 shown in Fig. 12 is identical to that shown in Fig. 10.

The configuration, the action, and the effect of the thin film inductor 100 other than those described above are identical to those in the above-mentioned thin film device 10, and therefore the descriptions thereof are omitted.

(Second Thin Film Inductor)

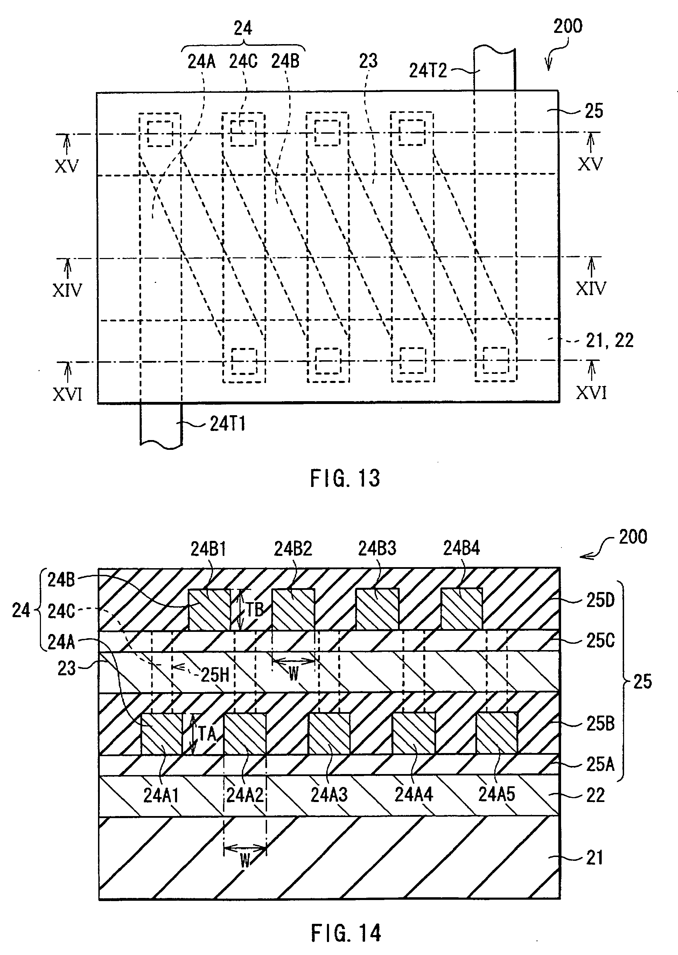

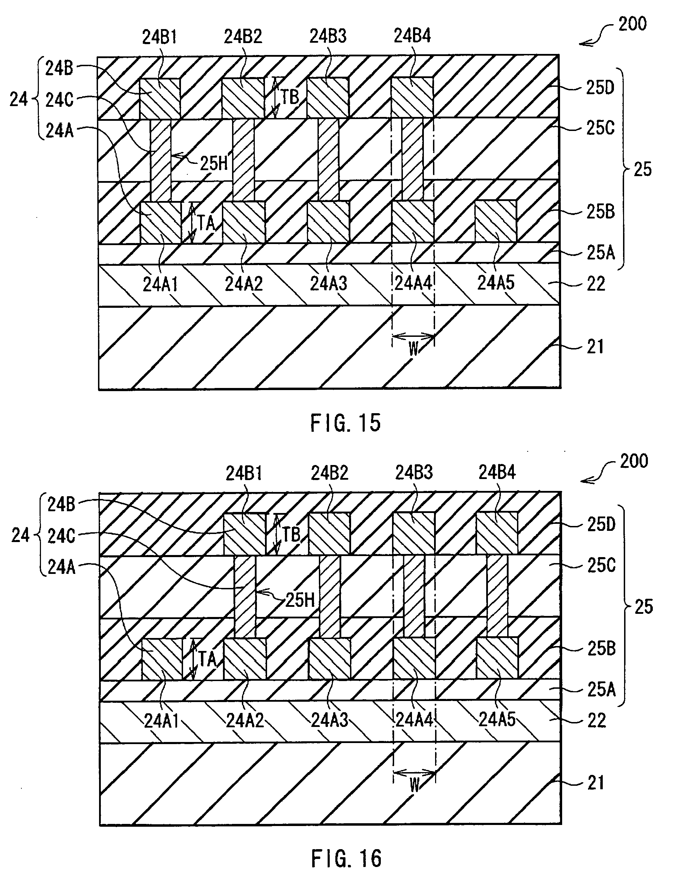

Figs. 13 to 16 show the configuration of a thin film inductor 200 to which applied is the thin film device 10; Fig. 13 shows its plan configuration; and Figs. 14 to 16 show cross-sectional configurations, respectively. More specifically, Figs. 14 to 16 show the cross-sectional configurations taken along the line VIV-VIV, the line XV-XV, and the line XVI -XVI in Fig. 13, respectively.

As shown in Figs. 13 to 16, the thin film inductor 200 has the configuration that a lower magnetic film 22, and an upper magnetic film 23 and a coil 24 each being filled in with an insulating film 25, are layered on a substrate 21. The lower magnetic film 22 and the upper magnetic film 23 are opposed to each other, and the coil 24 has a solenoid type structure wound around the upper magnetic film 23.

The substrate 21 corresponds to the substrate 1 (refer to Fig. 1), and has a surface roughness Ra expressed in the expressions (11) and (12). For example, the substrate 21 is constructed of the same material as the substrate 11 in the above-mentioned thin film inductor 100.

The lower magnetic film 22 and the upper magnetic film 23 correspond to the magnetic film 3 (refer to Fig. 1), respectively, and have a function of enhancing inductance. For example, the lower magnetic film 22 and the upper magnetic film 23 are constructed of the same magnetic material as in the lower magnetic film 12 and the upper magnetic film 17 in the above-mentioned thin film inductor 100, or a conductive magnetic material such as a nickel iron alloy (NiFe).

The coil 24 corresponds to the conductive film 2 (refer to Fig. 1), and is constructed of a conductive material such as copper. The coil 24 generates inductance in between one end (a terminal 24T1) and the other end (a terminal 24T2), and the terminal 24T1 and the terminal 24T2 are led out to the outside of the insulating film 25.

The coil 24 includes a plurality of strip lower and upper coil portions 24A and 24B, and a plurality of cylindrical intermediate coil portions 24C, each portion being connected in series. The lower coil portions 24A are arranged in a layer (a lower layer) between the lower magnetic film 22 and the upper magnetic film 23. The upper coil portions 24B are arranged in a layer (an upper layer) on the opposite side of the lower coil portions 24A with the upper magnetic film 23 interposed in between, so as to be overlapped with one end or the other end of the lower coil portions 24A. For example, these lower and upper coil portions 24A and 24B are of rectangular cross-section and of identical width W. The intermediate coil portions 24C are arranged at a layer between the lower layer and the upper layer, at which the lower coil portions 24A and the upper coil portions 24B are overlapped with each other. Here, the adhesiveness P expressed in the above-mentioned expression (12), namely an adhesiveness P per unit length of the coil 24 (the lower coil portions 24A and the upper coil portions 24B) corresponding to the conductive film 2, is substantially an adhesiveness P to the insulating film 25 (a lower insulating film 25A and an upper insulating film 25C).

The number of turns of the coil 24 can be set arbitrarily. In Figs. 13 to 16, there are shown, for example, the case where the number of turns of the coil 24 is four turns. In this case, for example, the use of the lower coil portions 24A as the terminals 24T1 and 24T2 allows five lower coil portions 24A (24A1 to 24A5) and four upper coil portions 24B (24B1 to 24B4) to be arranged.

The thickness TA of the lower coil portions 14A and the thickness TB of the upper coil portions 14B can be set arbitrarily. In Figs. 14 to 16, there are shown, for example, the case where the thickness TA and the thickness TB are identical.

The insulating film 25 electrically isolates the coil 24 from the lower magnetic film 22 and the upper magnetic film 23, and it is constructed of, for example, an insulating non-magnetic material such as silicon oxide, or an insulating resin material such as polyimide or resist. For example, the insulating film 25 includes a lower insulating film 25A deposited on the lower magnetic film 22, a lower coil insulating film 25B disposed on the lower insulating film 25A so as to fill in the lower coil portions 24A, an upper insulating film 25C disposed on the lower coil insulating film 25B so as to fill in the upper magnetic film 23, an upper coil insulating film 25D disposed on the upper insulating film 25C so as to fill in the upper coil portions 24B. In the lower coil insulating film 25B and the upper insulating film 25C, contact holes 25H are provided for each position where the lower coil portion 24A and the upper coil portion 24B are overlapped with each other. The intermediate coil portions 24C are buried in the contact holes 25H, respectively. The materials constituting a series of the insulating films 25A to 25D are not necessarily identical, and they may be set individually.

In the thin film inductor 200, the surface roughness Ra of the substrate 21 is within the range expressed in the expressions (11) and (12). Therefore, by the same action as the thin film device 10, the adhesion of the coil 24 can be ensured, and the magnetic characteristic (the magnetic permeability) of the lower magnetic film 22 and the upper magnetic film 23 can also be ensured. This enables to ensure operating performance. Otherwise, the effect and modifications of the thin film inductor 200 are identical to those of the above-mentioned thin film inductor 100.

<Examples>

Examples of the present invention will be described below.

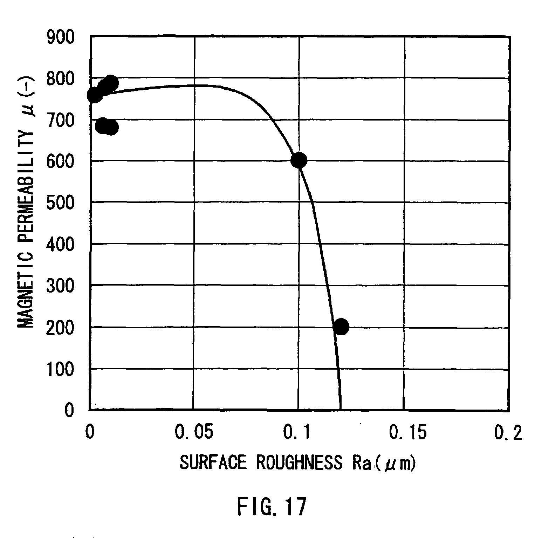

The magnetic characteristic of the thin film device described with reference to Fig. 7 in the foregoing embodiment was examined to obtain the results as presented in Fig. 17. Fig. 17 shows the correlation between surface roughness and magnetic permeability, on which the abscissa represents the surface roughness Ra ($\mu$m) of the substrate and the ordinate represents the magnetic permeability $\mu$ (-) of the magnetic film. In order to examine the magnetic characteristic, the thin film device was configured so that a substrate (silicon oxide), a magnetic film (cobalt zirconium tantalum alloy), and a conductive film (copper) were disposed vertically in the order named. Further, magnetic permeability was determined with a shield loop coil method.

As can be seen from the results presented in Fig. 17, the magnetic permeability $\mu$ became almost constant and was then lowered as the surface roughness Ra was increased. More specifically, the magnetic permeability $\mu$ was almost constant in the initial stage (Ra = 0.002 $\mu$m to 0.075 $\mu$m), and was lowered gently in the middle stage (Ra = 0.075 $\mu$m to 0.1 $\mu$m), and then lowered rapidly in the latter stage (Ra = 0.1 $\mu$m to 0.12 $\mu$m). This proves that in the thin film device of the present invention, the magnetic permeability $\mu$ can be ensured when the surface roughness Ra is within the range of 0.1 $\mu$m or less (Ra$\leqq$0.1 $\mu$m). This also proves that the magnetic permeability $\mu$ of the equivalent or more of the magnetic permeability $\mu$ when the surface roughness Ra is almost zero can be obtained especially when the surface roughness Ra is within the range of 0.075 $\mu$m or less (Ra$\leqq$0.075 $\mu$m).

While the present invention has been described taking the embodiment as example, it is to be understood that the present invention should not be limited to this embodiment but is susceptible of various changes and modifications. Specifically, the configuration of the thin film device or the thin film inductor can be changed freely as long as the surface roughness of the substrate falls within the range expressed in the above-mentioned expressions (11) and (12), and operating performance can be ensured by ensuring the adhesion of the conductive film or the coil and the magnetic characteristic of the magnetic film.

Although the foregoing embodiment has discussed the case where the thin film device of the present invention is applied to the thin film inductor, without limiting to this, the present invention may be applied to other devices other than the thin film inductor. Examples of the "other devices" are thin film transformers, thin film sensors, thin film resistors, thin film actuators, thin film magnetic heads, or MEMS, as described above. The applications of the thin film device of the present invention to these other devices also provide the same effect as in the foregoing embodiment.

It should be understood by those skilled in the art that various modifications, combinations, sub-combinations and alterations may occur depending on design requirements and other factors insofar as they are within the scope of the appended claims or the equivalents thereof.

**Claims**

1. A thin film device with a conductive film and a magnetic film each being layered on a substrate having a surface roughness within a range expressed in the following expression (1) and expression (2):

$$X \, \mu m \leqq Ra \leqq 0.1 \, \mu m \quad \cdots (1)$$

$$X = [(\sigma^2 T^2 W^2 - W^2 P^2) / 16 P^2]^{0.5} \quad \cdots (2)$$

where Ra is a surface roughness (an arithmetic mean roughness ($\mu$m)) of the substrate;

$\sigma$ is an internal stress (MPa) of the conductive film;
T is a thickness ($\mu$m) of the conductive film;
W is a peak-to-peak pitch ($\mu$m) of irregularities providing that concaves and convexes are uniformly formed on a surface of the substrate; and
P is adhesiveness (MPa) per unit length of the conductive film.

2. The thin film device according to claim 1 wherein the surface roughness of the substrate lies in a range expressed in the following expression (3):

$$\mathrm{Ra} \leqq 0.075 \, \mu m \quad \cdots (3)$$

3. The thin film device according to claim 1 wherein the surface roughness of the substrate lies in a range expressed in the following expression (4):

$$0.004 \, \mu m \leqq \mathrm{Ra} \quad \cdots (4)$$

4. The thin film device according to claim 1 wherein the conductive film includes a seed film and a plated film in that order from the substrate, the plated film being grown with use of the seed film.

5. A thin film inductor with a coil and a magnetic film each being layered on a substrate having a surface roughness within a range expressed in the following expression (5) and expression (6):

$$\mathrm{X} \, \mu m \leqq \mathrm{Ra} \leqq 0.1 \, \mu m \quad \cdots (5)$$

$$\mathrm{X} = [(\sigma^2 \mathrm{T}^2 \mathrm{W}^2 - \mathrm{W}^2 \mathrm{P}^2) / 16 \mathrm{P}^2]^{0.5} \quad \cdots (6)$$

where Ra is a surface roughness (an arithmetic mean roughness ($\mu$m)) of the substrate;

$\sigma$ is an internal stress (MPa) of the coil;
T is a thickness ($\mu$m) of the coil;
W is a peak-to-peak pitch ($\mu$m) of irregularities providing that concaves and convexes are uniformly formed on a surface of the substrate; and
P is adhesiveness (MPa) per unit length of the coil.

FIG. 1

FIG. 2

FIG. 3

FIG. 4

FIG. 5

FIG. 6

10

FIG. 7

10

FIG. 8

100

16

11, 12, 20, 17

16E1

16E2

FIG. 9

100

17

15
14    20
13

16

12

11

FIG. 10

100

FIG. 11

100

FIG. 12

FIG. 13

FIG. 14

FIG. 15

FIG. 16

FIG. 17

European Patent Office

## EUROPEAN SEARCH REPORT

Application Number

EP 06 02 0617

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 529 831 A (WAGA SATOSHI [JP] ET AL) 25 June 1996 (1996-06-25) * column 4, line 29 - line 42 * * column 5, line 17 - line 23 * | 1-3,5 | INV. H01F41/04 H01F17/04 H01F27/28 |
| Y | * column 5, line 25 - line 67 * | 4 | |
| P,Y | US 2006/152321 A1 (JUNG HYUNG M [KR] ET AL) 13 July 2006 (2006-07-13) * figure 3 * * page 4, paragraph 45 - paragraph 50 * | 4 | |
| Y | EP 1 467 216 A (SAMSUNG ELECTRONICS CO LTD [KR]) 13 October 2004 (2004-10-13) * claim 1 * | 4 | |
| Y | US 2002/105405 A1 (LEE SEUNG-YUN [KR] ET AL) 8 August 2002 (2002-08-08) * page 2, paragraph 35-37 * | 4 | |
| A | US 6 661 622 B1 (PINARBASI MUSTAFA [US]) 9 December 2003 (2003-12-09) * column 7, line 35 - line 60 * | 1-4 | TECHNICAL FIELDS SEARCHED (IPC) |
| A | US 2005/052267 A1 (SINGU MASAMICHI [JP] ET AL) 10 March 2005 (2005-03-10) * page 7, paragraph 124 * | 1-4 | H01F |
| A | BRANDON E J ET AL: "PRINTED MICROINDUCTORS ON FLEXIBLE SUBSTRATES FOR POWER APPLICATIONS" IEEE TRANSACTIONS ON COMPONENTS AND PACKAGING TECHNOLOGIES, IEEE SERVICE CENTER, PISCATAWAY, NJ, US, vol. 26, no. 3, September 2003 (2003-09), pages 517-523, XP001192672 ISSN: 1521-3331 * page 519, line 16 - line 27 * * page 519, line 38 - line 56 * | 1-5 | |

-/--

The present search report has been drawn up for all claims

| Place of search | Date of completion of the search | Examiner |
|---|---|---|
| Munich | 2 April 2007 | VAN DEN BERG, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................
& : member of the same patent family, corresponding document

EPO FORM 1503 03.82 (P04C01)

**European Patent Office**

**EUROPEAN SEARCH REPORT**

Application Number

EP 06 02 0617

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | JP 11 168010 A (YAMAHA CORP) 22 June 1999 (1999-06-22) * abstract * ----- | 1-5 | |
| D,A | JP 05 117838 A (DORYOKURO KAKUNENRYO; MITSUI SHIPBUILDING ENG) 14 May 1993 (1993-05-14) * abstract * ----- | 1-4 | |

TECHNICAL FIELDS SEARCHED (IPC)

The present search report has been drawn up for all claims

| Place of search | Date of completion of the search | Examiner |
|---|---|---|
| Munich | 2 April 2007 | VAN DEN BERG, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 02 0617

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2007

| Patent document cited in search report | | Publication date | Patent family member(s) | | Publication date |
|---|---|---|---|---|---|
| US 5529831 | A | 25-06-1996 | JP<br>JP | 3027081 B2<br>7161528 A | 27-03-2000<br>23-06-1995 |
| US 2006152321 | A1 | 13-07-2006 | CN<br>JP<br>KR | 1801412 A<br>2006190948 A<br>20060081493 A | 12-07-2006<br>20-07-2006<br>13-07-2006 |
| EP 1467216 | A | 13-10-2004 | JP<br>US | 2004258038 A<br>2005006713 A1 | 16-09-2004<br>13-01-2005 |
| US 2002105405 | A1 | 08-08-2002 | KR | 20010076787 A | 16-08-2001 |
| US 6661622 | B1 | 09-12-2003 | CN<br>JP<br>JP<br>KR<br>SG<br>US | 1333534 A<br>3650344 B2<br>2002124718 A<br>20020007995 A<br>94850 A1<br>2004206619 A1 | 30-01-2002<br>18-05-2005<br>26-04-2002<br>29-01-2002<br>18-03-2003<br>21-10-2004 |
| US 2005052267 | A1 | 10-03-2005 | CN | 1577651 A | 09-02-2005 |
| JP 11168010 | A | 22-06-1999 | NONE | | |
| JP 5117838 | A | 14-05-1993 | JP | 2682304 B2 | 26-11-1997 |

EPO FORM P0459

For more details about this annex : see Official Journal of the European Patent Office, No. 12/82

**EP 1 783 789 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 11168010 A
- JP 5117838 A